(19) Europäisches Patentamt
European Patent Office
Office européen des brevets

(11) **EP 2 533 418 B1**

(12) **FASCICULE DE BREVET EUROPEEN**

(45) Date de publication et mention
de la délivrance du brevet:
**19.02.2014 Bulletin 2014/08**

(51) Int Cl.:
***H03F 1/14*** (2006.01)

(21) Numéro de dépôt: **12170623.8**

(22) Date de dépôt: **01.06.2012**

(54) **Dispositif de neutrodynage d'un signal obtenu par transposition à une haute fréquence d'un signal utile fourni par un équipement**

Entkoppelungsvorrichtung eines Signals, das durch Umsetzung in eine hohe Frequenz eines von einem Gerät übertragenen nützlichen Signals erhalten wurde

Device for neutralising a signal obtained by high-frequency transposition of a useful signal provided by a device

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.06.2011 FR 1101783**

(43) Date de publication de la demande:
**12.12.2012 Bulletin 2012/50**

(73) Titulaire: **Thales**
**92200 Neuilly Sur Seine (FR)**

(72) Inventeur: **Muguet, Jean-Michel**
**26300 Rochefort-Samson (FR)**

(74) Mandataire: **Brunelli, Gérald**
**Marks & Clerk France**
**Immeuble Visium**
**22, avenue Aristide Briand**
**94117 Arcueil Cedex (FR)**

(56) Documents cités:
**US-A1- 2009 295 477     US-A1- 2010 148 875**

- **BENJAMIN J BLALOCK ET AL: "Designing 1-V Op Amps Using Standard Digital CMOS Technology", IEEE TRANSACTIONS ON CIRCUITS AND SYSTEMS II: ANALOG AND DIGITALSIGNAL PROCESSING/ISSN 1057-7130>VN 8090B, INSTITUTE OF ELECTRICAL AND ELECTRONICS ENGINEERS INC, 345 EAST 47 STREET, NEW YORK, N.Y. 10017, USA, vol. 45, no. 7, 1 juillet 1998 (1998-07-01), XP011012852, ISSN: 1057-7130**

**Description**

La présente invention concerne un dispositif de neutrodynage actif. Elle s'applique par exemple dans le domaine de l'électronique de traitement de l'information des capteurs de type microsystème électromécanique ou MEMS (acronyme de "Microelectromechanical systems" en langue anglaise.

L'électronique de traitement de l'information des capteurs et des détecteurs capacitifs peut nécessiter l'emploi d'une porteuse Haute Fréquence (HF) comme support de l'information utile, de l'ordre de 10 à 20 fois la fréquence du signal utile. Cette porteuse HF doit ensuite être éliminée ou réduite au niveau des étages d'amplification et de démodulation du signal utile à traiter. Le neutrodynage consiste à injecter, au niveau de ces étages, un signal en opposition de phase avec la porteuse HF. Le niveau du signal en opposition de phase permet d'annuler ou de réduire la porteuse HF et ainsi de favoriser le rapport signal à bruit et d'éviter la saturation des étages d'amplification et de démodulation du signal utile.

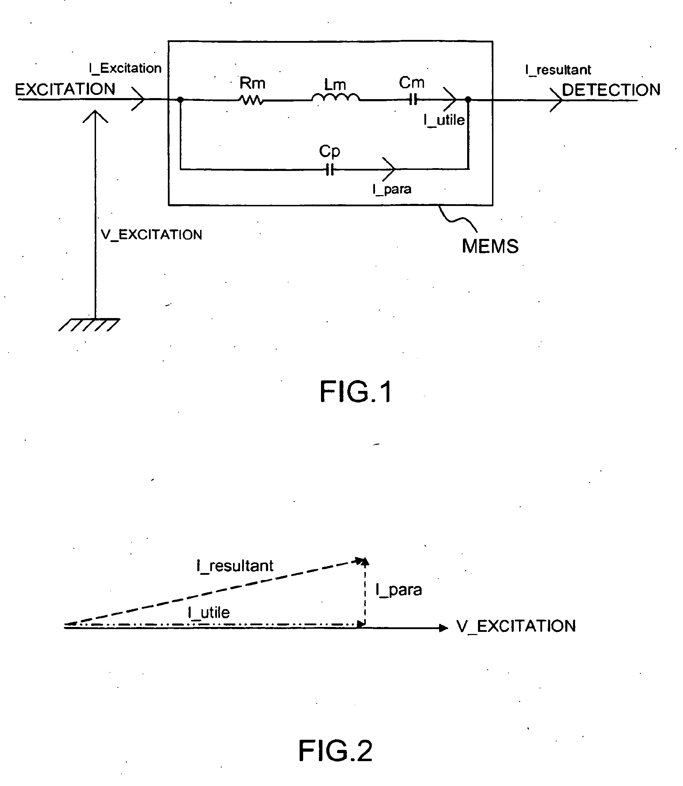

Par exemple, les capteurs MEMS nécessitent l'implantation d'une fonction de neutrodynage pour venir compenser la présence d'une capacité parasite Cp (intrinsèque à la conception ou "design" en langue anglaise) entre les électrodes de détection et d'excitation. Le schéma équivalent du capteur MEMS ou résonateur est représenté par le circuit de type RLC (Rm, Lm et Cm) de la figure 1.

Des exemples de compensation de la capacité parasite peuvent être trouvés dans les documents de brevet US2009/295477 et US2010/148875, ainsi que dans Benjamin J Blalock et al, "Designing 1-V Op Amps Using Standard Digital CMOS Technology" (IEEE Transactions on Circuits and Systems II: Analog and Digital Signal, July 1998).

Du fait de la présence de la capacité parasite Cp, une partie du courant d'excitation I_excitation est dérivé dans la capacité parasite Cp et perturbe ainsi la mesure. Le courant résultant I_resultant n'étant plus égal et en phase avec le courant utile I_utile qui traverse le circuit de type RLC (Rm, Lm et Cm). A la résonance, I_utile est en phase avec V_Excitation. La figure 2 est une représentation de Fresnel des différents courants.

Le neutrodynage consiste à ramener le courant résultant I_resultant égal et en phase avec le courant utile I_utile.

Comme explicité dans la suite de la présente demande, les techniques actuelles de neutrodynage nécessitent un réglage au travers de potentiomètres ou de dispositifs similaires. D'une part, ce réglage doit être réalisé sur chaque capteur ou détecteur de manière individuelle, car le niveau à régler est souvent directement lié à des capacités parasites mal maîtrisées dans le capteur ou le détecteur. D'autre part, ce réglage étant effectué une fois pour toutes lors des phases initiales de production du capteur ou du détecteur, toute variation ultérieure ou dérive ne peut pas être compensée.

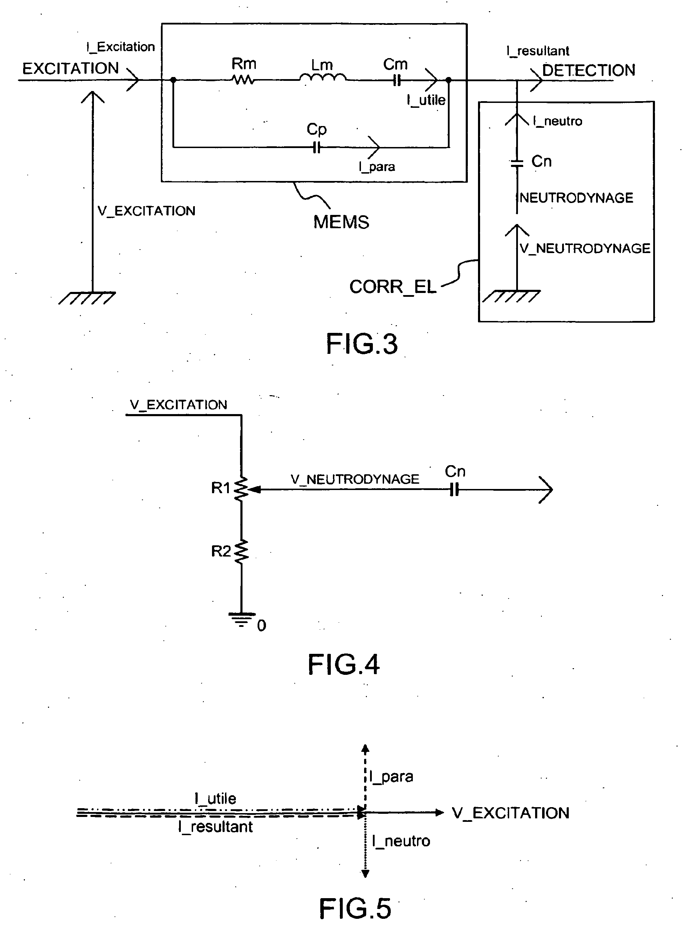

Auparavant, ce problème était résolu en réalisant du neutrodynage dit passif, comme illustré sur le dispositif des figures 3, 4 et 5, dans lequel un courant électrique de neutrodynage I_neutro est injecté, au travers dune capacité Cn, égal et opposé au courant électrique parasite I_para. Les courants électriques résultant après neutrodynage I_resultant, et utile I_utile en sortie du capteur MEMS redevenaient égaux et en Phase.

La figure 5 illustre une représentation de Fresnel de ces courants.

Pour compenser parfaitement le courant électrique parasite I_para avec le courant électrique de neutrodynage I_neutro, il faut respecter les relations suivantes:

La loi des noeuds sur la figure 3 donne la relation suivante :

$$I\_resultant = I\_utile + I\_para + I\_neutro$$

Or on souhaite que I_resultant = I_utile.
Il faut donc que I_neutro = - I_para
Avec I_neutro = Cn×{d(V_NEUTRODYNAGE)/dt} et I_para = Cp × {d(V_EXCITATION)/dt}.
En passant en variable de Laplace: p = j×w avec w = 2 × $\pi$ × f et j représente l'unité imaginaire d'un nombre complexe, on trouve :

$$I\_neutro = Cn \times j \times w \times V\_NEUTRODYNAGE$$

et

$$I\_para = Cp \times j \times w \times V\_EXCITATION.$$

Comme on souhaite que I_neutro = - I_para soit :

$$Cn \times V\_NEUTRODYNAGE = -Cp \times V\_EXCITATION$$

Si Cn = Cp alors

$$V\_NEUTRODYNAGE = -V\_EXCITATION$$

Toutefois, il est impossible de trouver un condensateur ou capacité de valeur Cn qui soit exactement égal à la valeur de capacité parasite Cp, car les valeurs des capacités sont normées et prédéfinies, donc de choix restreint de valeurs.

Ainsi, comme on a la relation suivante :

$Cn \times V\_NEUTRODYNAGE = -V\_EXCITATION \times Cp$, on choisit une valeur de Cn = k×Cp avec k>1. Il faut donc régler la tension électrique V_NEUTRODYNAGE à la tension électrique -V_EXCITATION/k. Le signe négatif précise qu'il faut une opposition de phase parfaite entre V_NEUTRODYNAGE et V_EXCITATION/k, k étant supérieur à 1, et le ratio 1/k montrant qu'il faut réaliser un atténuateur.

Le gain G (ou plutôt l'atténuation) égal à 1/k, était obtenu par un pont diviseur réalisé avec un potentiomètre et une résistance (cf figure 4). Ce gain ou atténuation était réglé en usine en dur au début de la vie du produit. De tels dispositifs présentent divers inconvénients, notamment, un réglage manuel de la tension électrique de neutrodynage à l'aide de potentiomètres, qui, effectué une fois à température ambiante, ne s'adapte pas aux variations engendrées par des dérives en températures et par des dérives dues aux modifications ou dégradations de fonctionnement des capteurs MEMS au cours du temps.

La figure 4 illustre un exemple de neutrodynage passif.

Il est connu, comme décrit dans la demande de brevet français FR 1005079, des dispositifs mettant en oeuvre un neutrodynage actif qui s'adapte en permanence de manière à optimiser le niveau résiduel de la porteuse HF. A cet effet, la demande de brevet français FR 1005079 a pour objet un dispositif de neutrodynage d'un signal obtenu par transposition à une haute fréquence d'un signal utile fourni par un équipement, ledit équipement ayant une capacité parasite Cp qui varie dans le temps. Le dispositif comporte une capacité de neutrodynage Cn et des moyens à gain G ajustable, ainsi que des moyens pour asservir le gain G de telle sorte que, en permanence, GxCn=Cp. Par exemple, les moyens à gain G ajustable peuvent inclure un transistor de type JFET, les moyens pour asservir pouvant commander ledit transistor en tension de manière à ajuster son gain.

Un transistor de type JFET, acronyme de "Junction Field Effect Transistor" en langue anglaise, est un transistor à effet de champ dont la grille est directement en contact avec le canal. Un transistor de type JFET est commandé en tension (le courant électrique au niveau du drain dépend de la tension électrique Vgs entre la grille et la source).

Un tel neutrodynage actif permet, au moyen d'un asservissement, de contrôler la tension électrique de neutrodynage en continu de manière à ce que le courant électrique de neutrodynage I_neutro compense en permanence le courant électrique parasite I_para. Cette solution ne nécessite plus de réglages manuels (ordre de grandeur de gain en RC : 50 € par capteur) et permet une compensation des dérives dues aux variations de températures et au temps.

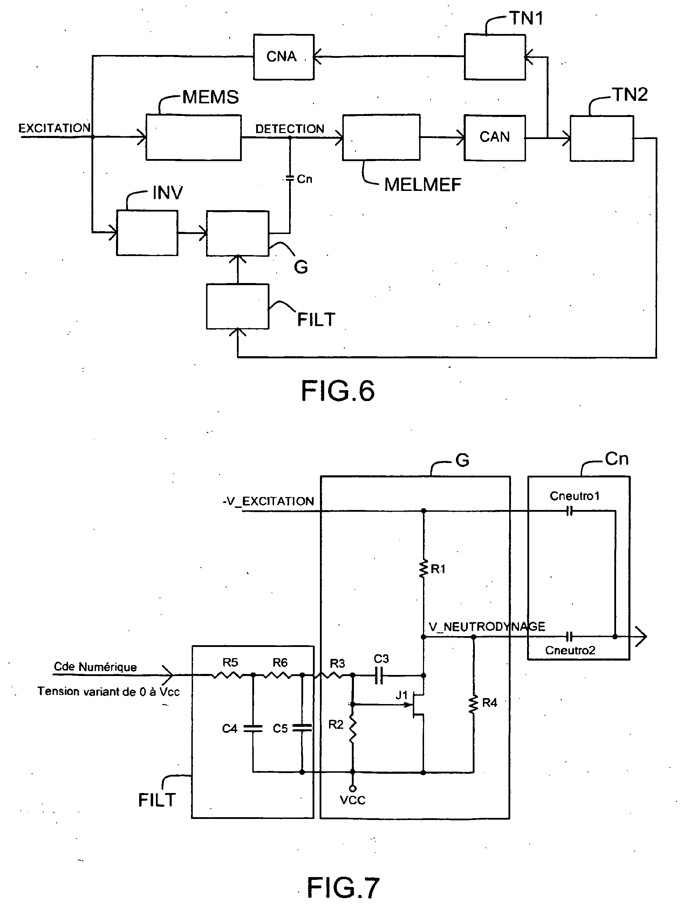

La figure 6 illustre schématiquement, dans son ensemble, un dipositif de neutrodynage d'un capteur MEMS.

Le capteur MEMS est un élément sensible qui capte la grandeur physique (accélération, pression, rotation, champ magnétique, etc...). Un module électronique de mise en forme MELMEF permet de convertir le mouvement mécanique du capteur MEMS en grandeur électrique (tension) et de le mettre à niveau (amplitude suffisante). Un convertisseur analogique/numérique CAN permet de convertir le signal analogique en un signal numérique. Un premier module de traitement numérique TN1 permet de garantir l'entretien du mouvement mécanique du capteur MEMS en réalisant des asservissements. Un convertisseur numérique/analogique CNA permet de convertir le signal numérique en un signal analogique transmis à un inverseur INV, ainsi qu'en entrée du capteur MEMS. L'inverseur INV permet d'inverser le signal d'excitation EXCITATION du capteur MEMS pour créer le signal inverse -EXCITATION et réaliser la fonction de neutrodynage. Un module de gain G de valeur G=1/k permet de réaliser un atténuateur à gain variable. Un deuxième module de traitement numérique TN2 réalise l'asservissement afin d'envoyer la bonne commande sur le transistor JFET du module de gain G. Un module de filtrage FILT permet de filtrer le signal numérique en provenance du deuxième module de traitement numérique TN2 afin de pouvoir commander en tension électrique continue le transistor JFET (tension électrique Vgs).

Toutefois, pour que le neutrodynage actif fonctionne correctement, il faut réaliser un atténuateur à gain variable dont le déphasage et la distorsion restent négligeable.

On entend par distorsion, la déformation ou l'altération du signal sinusoïdal créant dans le domaine fréquentiel une multitude de raies parasites.

Un but de l'invention est de pallier les problèmes précédemment cités.

Il est proposé, selon un aspect de l'invention, un dispositif de neutrodynage d'un signal obtenu par transposition à une haute fréquence d'un signal utile fourni par un équipement comprenant une capacité parasite Cp variant dans le temps, le dispositif comprenant une capacité de neutrodynage Cn, des moyens de gain G de valeur ajustable, munis d'un transistor à effet de champ de type JFET muni d'une première électrode de grille et de deuxièmes électrodes de drain et de source, et des moyens d'asservissement desdits moyens de gain G de sorte que, en permanence, GxCn=Cp, par commande en tension électrique de la première électrode de grille du transistor. La capacité de neutrodynage comprend une première capacité Cneutro1 et une deuxième capacité Cneutro2 disposées en parallèle en sortie desdits moyens de gain. En d'autres termes, la capacité de neutrodynage Cn comprend une première capacité Cneutro1 et une deuxième capacité Cneutro2 disposées sur des branches de sortie parallèles desdits moyens de gain G.

Un tel dispositif permet de contrôler dynamiquement la compensation du courant parasite I_para au cours du temps et des variations de température en minimisant le déphasage et la distorsion sur le signal V_NEUTRODYNAGE

Selon un mode de réalisation, les première capacité et deuxième capacité disposées en parallèle sont reliées par une première résistance électrique des moyens de gain.

Ainsi, la première capacité Cneutro1 permet de réaliser une compensation grossière de la capacité parasite Cp alors que la deuxième capacité Cneutro2 permet de réaliser un réglage affiné de la compensation. Cette ségrégation en deux capacités permet également d'avoir une amplitude faible sur la tension Vds du transistor JFET J1 afin de limiter la distorsion du signal V_NEUTRODYNAGE.

Dans un mode de réalisation, les moyens de gain G comprennent une deuxième résistance électrique appliquée d'une part à la première électrode de grille dudit transistor, et d'autre part à une deuxième électrode de source dudit transistor.

Cette deuxième résistance permet de polariser le transistor J1 en l'absence de commande numérique.

Selon un mode de réalisation, lesdits moyens de gain comprennent, en outre, une troisième résistance électrique reliée en série avec ladite première électrode de grille dudit transistor, et une troisième capacité reliée directement d'une part à la première électrode de grille du transistor, et d'autre part à une deuxième électrode de drain du transistor, reliée directement à la deuxième capacité.

Cette troisième capacité et cette troisième résistance électrique permettent de limiter la distorsion sur le signal présent sur le drain du transistor.

Dans un mode de réalisation, lesdits moyens de gain comprennent, en outre, une quatrième résistance électrique montée en parallèle des deuxièmes électrodes de drain et de source du transistor.

Cette quatrième résistance permet de limiter l'amplitude de la tension électrique aux bornes du transistor J1 au démarrage, et ainsi de limiter la distorsion.

Par exemple, l'équipement peut comprendre un microsystème électromécanique ou capteur MEMS, tel un gyromètre.

L'invention sera mieux comprise à l'étude de quelques modes de réalisation décrits à titre d'exemples nullement limitatifs et illustrés par les dessins annexés sur lesquels :

- les figures 1, 2, 3, 4, 5, et 6 illustrent schématiquement des modes de réalisations connus de dispositifs de neutrodynage passifs d'un signal obtenu par transposition à une haute fréquence d'un signal utile fourni par un équipement tel un capteur MEMS ; et
- la figure 7 illustre un dispositif de neutrodynage actif d'un signal obtenu par transposition à une haute fréquence d'un signal utile fourni par un équipement comprenant une capacité parasite, selon un aspect de l'invention.

Sur la figure 7, est représenté schématiquement un dispositif de neutrodynage d'un signal obtenu par transposition à une haute fréquence d'un signal utile fourni par un équipement comprenant une capacité parasite, selon un aspect de l'invention.

Le dispositif comprend un module de filtrage FILT, un module de gain G et une capacité de neutrodynage Cn.

La capacité de neutrodynage Cn comprend une première capacité Cneutro1 et une deuxième capacité Cneutro2 disposées en parallèle en sortie des moyens de gain G. En d'autres termes, la capacité de neutrodynage Cn comprend une première capacité Cneutro1 et une deuxième capacité Cneutro2 disposées sur des branches de sortie parallèles desdits moyens de gain G.

La loi des noeuds sur la figure 3 donne la relation suivante :

$$I\_resultant = I\_utile + I\_para + I\_neutro$$

avec I_neutro = I_neutro1 + I_neutro2

Or on souhaite que I_resultant = I_utile.

Il faut donc que I_neutro = -I_para soit I_neutro1 + I_neutro2 = -I_para Avec I_neutro1 = Cneutro1 × {d(-V_EXCITATION)/dt},

I_neutro2 = Cneutro2 × {d(V_NEUTRODYNAGE)/dt} et

I_para = Cp × {d(V_EXCITATION)/dt}.

En passant en variable de Laplace: p = j×w avec w = 2 × π × f,

j représentant l'unité imaginaire d'un nombre complexe, on trouve :

$$I\_neutro1 = Cneutro1 \times j \times w \times (-V\_EXCITATION),$$

$$I\_neutro2 = Cneutro2 \times j \times w \times V\_NEUTRODYNAGE$$

et

$$I\_para = Cp \times j \times w \times V\_EXCITATION.$$

Comme on souhaite que I_neutro1 + I_neutre2 = - I_para soit :

$$Cneutro1 \times (-V\_EXCITATION) + Cneutro2 \times V\_NEUTRODYNAGE = -Cp \times V\_EXCITATION$$

dans laquelle V_NEUTRODYNAGE = -V_EXCITATION/k On obtient donc:

$$Cneutro1 + Cneutro2 / k = Cp$$

Une telle réalisation de capacité de neutrodynage Cn permet de réaliser une compensation grossière de la capacité parasite Cp avec la première capacité Cneutro1 alors que la capacité Cneutro2 permet de réaliser un réglage affiné de la compensation. Cette ségrégation en deux capacités permet également d'avoir une amplitude faible sur la tension Vds du transistor JFET J1 afin de limiter la distorsion du signal V_NEUTRODYNAGE.

La première capacité Cneutro1 est choisie à une valeur normalisée inférieure à la plus petite capacité parasite Cp à compenser. Elle doit compenser entre 75 % et 95 % de la valeur de Cp.

Concernant la deuxième capacité Cneutro2, la valeur dépend du gain 1/k choisit et de la valeur de Cneutro1. Plus la valeur de k est importante et plus la tension Vds aux bornes de transistor J1 est faible et plus la distorsion est faible. Il est courant de prendre une valeur de k comprise entre 10 et 100. Ainsi la valeur de Cneutro2 pourrait prendre des valeurs comprises entre Cp/2 et 25 × Cp.

L'équipement, par exemple un capteur MEMS, tel un gyromètre, comprend une capacité parasite Cp variant dans le temps. Le module de gain G a une valeur Gain ajustable.

Le module de gain G est muni d'un transistor à effet de champ J1 de type JFET muni d'une première électrode de grille et de deuxièmes électrodes de drain et de source. Le module de gain G comprend également un asservissement des moyens de gain G de sorte que, en permanence, GainxCn=Cp, par commande en tension électrique de la première électrode de grille du transistor J1.

Le transistor JFET J1 à Canal N permet de réaliser une résistance variable (résistance électrique drain/source notée Rds) en fonction de la commande qui lui est appliquée sur la grille (tension électrique grille/source notée Vgs). L'expression suivante lie la résistance électrique Rds (en Ohm) à la tension électrique de grille Vgs (en Volts), avec la tension électrique de pincement Vp (en Volts) et le courant électrique de saturation Idss (en Ampères) :

$$Rds(Vgs) = \frac{1}{2\dfrac{Idss}{Vp^2}.(Vgs - Vp)}$$

Les première capacité Cneutro1 et deuxième capacité Cneutro2 disposées en parallèle sont reliées par une première résistance électrique R1 des moyens de gain G.

Le module de gain G comprennent une deuxième résistance électrique R2 appliquée d'une part à la première électrode de grille dutransistor J1, et d'autre part à une deuxième électrode de source du transistor J1.

Le module de gain G comprend, en outre, une troisième résistance électrique R3 reliée en série avec ladite première électrode de grille dudit transistor J1, et une troisième capacité C3 reliée directement d'une part à la première électrode de grille dudit transistor J1, et d'autre part à une deuxième électrode de drain du transistor J1, reliée directement à la deuxième capacité Cneutro2.

La présence de cette troisième capacité C3 est de limiter la distorsion sur le signal présent sur le drain du transistor J1.

Le module de gain G comprend, en outre, une quatrième résistance électrique R4 montée en parallèle des deuxièmes électrodes de drain et de source du transistor J1.

Un exemple de réalisation du module de filtrage FILT peut être celui représenté à la figure 7 comprennent une cinquième résistance électrique R5 et une sixième résistance électrique R6 montés en série, ainsi qu'une quatrième capacité C4 et une cinquième capacité C5 montées en parallèle entre-elles, et une borne de la quatrième capacité C4 étant connectée entre les cinquième et sixième résistance R5 et R6, et une borne de la cinquième capacité C5 étant connectée à l'autre borne de la sixième résistance R6.

La première résistance R1 et le transistor J1 forment ainsi un pont diviseur de tension, et la quatrième résistance R4 permet de limiter le gain et l'amplitude aux bornes du transistor J1.

Le module de filtrage FILT composé de deux cellules RC (R5/C4 et R6/C5) permet de transformer la commande numérique à Haute Fréquence en une tension électrique continue pouvant varier de 0 à Vcc (Vcc étant la tension électrique d'alimentation des entrées/sorties du coeur numérique) selon le rapport cyclique de la commande numérique. La commande numérique est un signal modulé en largeur de bande PWM pour "Pulse Width Modulation" en langue anglaise.

La troisième capacité C3 permet d'atténuer la distorsion et les deuxième et troisième résistances R2 et R3 permettent de mettre à niveau la tension électrique de commande de grille. La deuxième résistance R2 permet également de fixer le potentiel électrique de la grille en l'absence de commande numérique, notamment au démarrage.

Afin de polariser le transistor JFET J1 correctement, il est nécessaire de commander la tension électrique Vgs avec une tension négative variant de Vp à 0 Volts, Vp étant la tension électrique de pincement du transistor J1 dont la valeur est négative.

Les tensions électriques de la commande numérique étant positives et ne pouvant varier qu'entre 0 Volts et Vcc, il est nécessaire de polariser la source du transistor J1 sous la tension électrique Vcc pour obtenir la tension électrique Vgs négative.

Il faut donc choisir un transistor dont la tension de pincement Vp est supérieure ou égale à -Vcc. Par exemple, pour une tension Vcc de 3 V, le transistor PMBF4393 pourrait être un bon candidat, et pour une tension Vcc de 5 V, le transistor PMBF4392 pourrait être un bon candidat.

La première capacité Cneutro1 permet de compenser environ 75% à 95% de la valeur de la capacité parasite Cp et les 5% à 25% restant sont compensés par le pont diviseur (constitué de R1, R4 et J1) et la deuxième capacité Cneutro2. Ainsi l'amplitude de la tension électrique aux bornes de J1 (Vds entre drain et source) est plus faible et la distorsion est limitée.

L'invention permet ainsi la génération d'une fonction électronique permettant de réaliser un atténuateur à gain variable à partir d'une commande numérique sans générer de déphasage trop important autour de 200kHz entre le signal d'entrée et le signal de sortie.

Elle permet également la génération d'une fonction électronique permettant de réaliser un atténuateur à gain variable à partir d'une commande numérique sans générer de distorsion trop importante autour de 200kHz entre le signal d'entrée et le signal de sortie.

L'invention permet, en outre, grâce à l'injection du signal de compensation au travers de deux capacités de neutrodynage, d'atténuer fortement la distorsion du signal V_NEUTRODYNAGE.

**Revendications**

1. Dispositif de neutrodynage d'un signal obtenu par transposition à une haute fréquence d'un signal utile fourni par un équipement comprenant une capacité parasite Cp variant dans le temps, le dispositif comprenant une capacité de neutrodynage Cn, des moyens de gain G de valeur ajustable, munis d'un transistor à effet de champ (J1) de type JFET muni d'une première électrode de grille et de deuxièmes électrodes de drain et de source, et des moyens d'asservissement desdits moyens de gain G de sorte que, en permanence, GxCn=Cp, par commande en tension électrique de la première électrode de grille du transistor (J1), **caractérisé en ce que** la capacité de neutrodynage Cn comprend une première capacité Cneutro1 et une deuxième capacité Cneutro2 disposées sur des branches de sortie parallèles desdits moyens de gain G.

2. Dispositif selon la revendication 1, dans lequel les première capacité Cneutro1 et deuxième capacité Cneutro2 disposées en parallèle sont reliées par une première résistance électrique (R1) des moyens de gain G.

3. Dispositif selon la revendication 1 ou 2, dans lequel les moyens de gain G comprennent une deuxième résistance électrique (R2) appliquée d'une part à la première électrode de grille dudit transistor (J1), et d'autre part à une deuxième électrode de source dudit transistor (J1).

4. Dispositif selon l'une des revendications précédentes, dans lequel lesdits moyens de gain G comprennent, en outre, une troisième résistance électrique (R3) reliée en série avec ladite première électrode de grille dudit transistor (J1), et une troisième capacité (C3) reliée directement d'une part à la première électrode de grille dudit transistor (J1), et d'autre part à une deuxième électrode de drain dudit transistor (J1), reliée directement à ladite deuxième capacité Cneutro2.

5. Dispositif selon l'une des revendications précédentes, dans lequel lesdits moyens de gain G comprennent, en outre, une quatrième résistance électrique (R4) montée en parallèle des deuxièmes électrodes de drain et de source du transistor (J1)

6. Dispositif selon l'une des revendications précédentes, dans lequel l'équipement comprend un microsystème électromécanique (MEMS).

7. Dispositif selon la revendication 6, dans lequel la cellule MEMS est un gyromètre.

**Patentansprüche**

1. Vorrichtung zum Neutralisieren eines Signals, das durch Transposition eines Nutzsignals auf eine hohe Frequenz erhalten wurde, das von einem Gerät geliefert wird, das eine mit der Zeit variierende parasitäre Kapazität Cp aufweist, wobei die Vorrichtung Folgendes umfasst: eine Neutralisierungskapazität Cn, justierbare Verstärkungsmittel G, versehen mit einem Feldeffekttransistor (J1) des JFET-Typs, versehen mit einer ersten Gate-Elektrode sowie mit einer zweiten Drain- und Source-Elektrode, und Mittel zum Regeln der Verstärkungsmittel G, so dass ständig GxCn=Cp, durch Regeln der elektrischen Spannung der ersten Gate-Elektrode des Transistors (J1), **dadurch gekennzeichnet, dass** die Neutralisierungskapazität Cn eine erste Kapazität Cneutro1 und eine zweite Kapazität Cneutro2 umfasst, die auf Ausgangszweigen parallel zu den Verstärkungsmitteln G vorgesehen sind.

2. Vorrichtung nach Anspruch 1, wobei die erste Kapazität Cneutro1 und die parallel dazu geschaltete zweite Kapazität Cneutro2 durch einen ersten elektrischen Widerstand (R1) der Verstärkungsmittel G verbunden sind.

3. Vorrichtung nach Anspruch 1 oder 2, wobei die Verstärkungsmittel G einen zweiten elektrischen Widerstand (R2) umfassen, der einerseits auf die erste Gate-Elektrode des Transistors (J1) und andererseits auf eine zweite Source-Elektrode des Transistors (J1) angewandt wird.

4. Vorrichtung nach einem der vorherigen Ansprüche, wobei die Verstärkungsmittel G ferner einen dritten elektrischen Widerstand (R3) umfassen, der in Serie mit der ersten Gate-Elektrode des Transistors (J1) verbunden ist, und eine dritte Kapazität (C3), die einerseits direkt mit der ersten Gate-Elektrode des Transistors (J1) und andererseits mit einer zweiten Drain-Elektrode des Transistors (J1) verbunden ist, die direkt mit der zweiten Kapazität Cneutro2 verbunden ist.

**5.** Vorrichtung nach einem der vorherigen Ansprüche, wobei die Verstärkungsmittel G ferner einen vierten elektrischen Widerstand (R4) umfassen, der parallel zu den zweiten Drain- und Source-Elektroden des Transistors (J1) geschaltet ist.

**6.** Vorrichtung nach einem der vorherigen Ansprüche, wobei das Gerät ein mikroelektromechanisches System (MEMS) umfasst.

**7.** Vorrichtung nach Anspruch 6, wobei die MEMS-Zelle ein Gyrometer ist.

**Claims**

**1.** A device for neutralising a signal obtained by high frequency transposition of a useful signal supplied by an item of equipment comprising parasitic capacitance Cp that varies over time, said device comprising a neutralising capacitance Cn, gain means G with adjustable value, provided with a JFET type field-effect transistor (J1) provided with a first gate electrode and second drain and source electrodes, and means for servo-controlling said gain means G so that GxCn continuously equals Cp, by controlling the electrical voltage of the first gate electrode of the transistor (J1), **characterised in that** the neutralising capacitance Cn comprises a first capacitance Cneutro1 and a second capacitance Cneutro2 disposed on the output branches parallel to said gain means G.

**2.** The device according to claim 1, wherein the first capacitance Cneutro1 and the second capacitance Cneutro2 connected in parallel are connected by a first electrical resistor (R1) of said gain means G.

**3.** The device according to claim 1 or 2, wherein the gain means G comprise a second electrical resistor (R2) applied on the one hand to the first gate electrode of said transistor (J1) and on the other hand to a second source electrode of said transistor (J1).

**4.** The device according to any one of the preceding claims, wherein said gain means G further comprise a third electrical resistor (R3) connected in series to said first gate electrode of said transistor (J1), and a third capacitor (C3) directly connected on the one hand to the first gate electrode of said transistor (J1) and on the other hand to a second drain electrode of said transistor (J1) directly connected to said second capacitor Cneutro2.

**5.** The device according to any one of the preceding claims, wherein said gain means G further comprise a fourth electrical resistor (R4) mounted parallel to the second drain and source electrodes of said transistor (J1).

**6.** The device according to any one of the preceding claims, wherein said item of equipment comprises a micro-electromechanical system (MEMS).

**7.** The device according to claim 6, wherein the MEMS cell is a gyrometer.

I_Excitation

EXCITATION

Rm    Lm    Cm

I_resultant
DETECTION

I_utile

Cp

I_para

V_EXCITATION

MEMS

FIG.1

I_resultant

I_para

I_utile

V_EXCITATION

FIG.2

EXCITATION

I_Excitation

Rm        Lm        Cm

I_utile

Cp

I_para

V_EXCITATION

MEMS

I_resultant

DETECTION

I_neutro

Cn

NEUTRODYNAGE

V_NEUTRODYNAGE

CORR_EL

## FIG.3

V_EXCITATION

R1

V_NEUTRODYNAGE    Cn

R2

0

## FIG.4

I_para

I_utile

I_resultant

V_EXCITATION

I_neutro

## FIG.5

## FIG.6

**FIG.6**

## FIG.7

**FIG.7**

**EP 2 533 418 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2009295477 A
- US 2010148875 A
- FR 1005079

**Littérature non-brevet citée dans la description**

- **BENJAMIN J BLALOCK et al.** Designing 1-V Op Amps Using Standard Digital CMOS Technology. *IEEE Transactions on Circuits and Systems II: Analog and Digital Signal,* Juillet 1998